# EUROPEAN PATENT APPLICATION

(11) **EP 2 330 622 A1**
(43) Date of publication of application: **08.06.2011**
(21) Application number: 10194067.4
(22) Date of filing: 07.12.2010
(51) Int. Cl.: H01L 25/07

(54) **Solid state switch arrangement**

(30) Priority: 07.12.2009 US 632042
(71) Applicant: Hamilton Sundstrand Corporation, Windsor Locks, CT 06096-1010 (US)
(72) Inventor: Schnetker, Ted R., Rockford, IL 61107 (US); Sytsma, Steven J., Waukegan, IL 60085 (US)
(74) Representative: Tomlinson, Kerry John

(57) **Abstract**

A solid state switching arrangement (11) includes at least one bus bar (18a) configured to carry electrical current and at least one switch (14) that is gallium nitride based. The switch is secured relative to the bus bar and the bus bar is configured to communicate heat away from the switch. An example method of arranging a switch includes mounting a gallium nitride based switch relative to a bus bar and communication heat away from the gallium nitride based switch using the bus bar.

## Description

### BACKGROUND

This disclosure relates generally to switches, and more specifically, to a mounting arrangement of solid state switches.

Solid state switches are used with many types of electrical units, such as power conversion units, motor control units, power switching units, and power distribution units. In a typical electrical unit the solid state switches are mounted away from the bus bars, and are then electrically coupled to the bus bar which they control. All switches generate heat during operation. Interconnects and heat sinks are often incorporated into the unit to move heat generated during operation away from the switches and reduce waste heat build-up.

### SUMMARY

An example solid state switching arrangement includes a bus bar configured to carry electrical current and at least one semi-conductor switch that is gallium nitride based. The switch is secured to the bus bar.

An example solid state switching arrangement includes at least one solid state switch and a bus bar configured to carry alternating electrical current. The at least one solid state switch is directly mounted to the bus bar.

An example method of arranging a switch includes mounting a gallium nitride based switch relative to a bus bar and communicating heat away from the gallium nitride based switch using the bus bar.

These and other features of the example disclosure can be best understood from the following specification and drawings, the following of which is a brief description.

### BRIEF DESCRIPTION OF THE DRAWINGS

Figure 1 illustrates a block diagram of a gallium nitride based switch directly mounted to a bus bar.
Figure 2 shows a partial view of an example mounting arrangement of solid state switches.
Figure 3 schematically shows another example mounting arrangement of solid state switches.
Figure 4 shows yet another example mounting arrangement of solid state switches.

### DETAILED DESCRIPTION

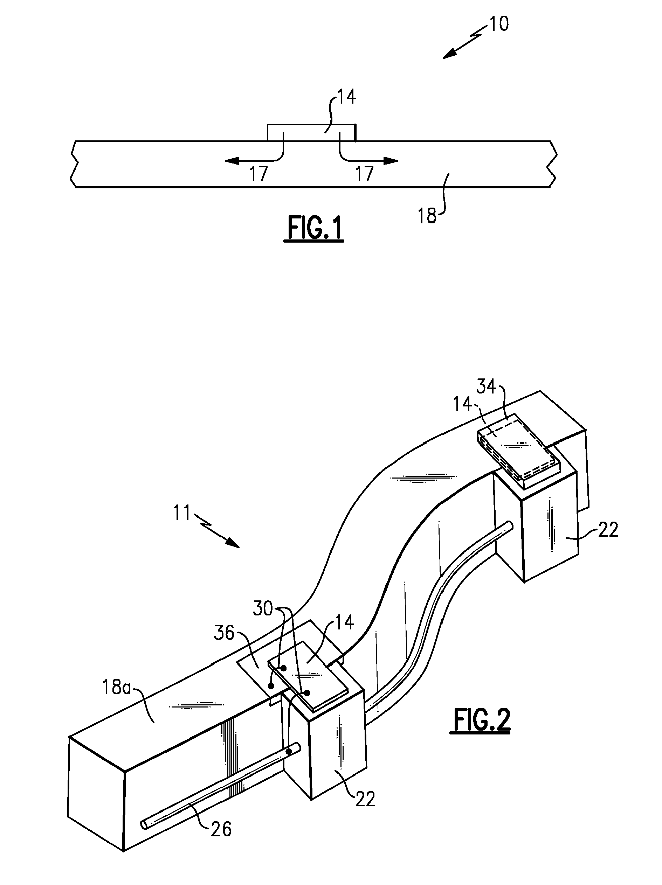

Figure 1 illustrates a block diagram of a mounting arrangement 10 that includes a switch 14 mounted to a bus bar 18. The switch 14 may be a gallium nitride based semiconductor switch, such as a transistor. For instance, a gallium nitride semiconductor switch is a semiconductor switch where gallium nitride is used in a similar manner to silicon or silicon carbide in a silicon based semiconductor switch. The use of gallium nitride in place of the silicon provides material and functional benefits which are described below. The singular bus bar 18 can be either a standard bus bar, which carries electrical current in a single direction, or an alternating current bus bar, which alternates the direction of current between the positive and the negative direction. The switch 14 is thermally connected to the bus bar 18 such that the bus bar 18 is a heat sink for removing heat generated in the switch 14 along a flow path 17.

Figure 2 shows another example mounting arrangement 11 including multiple solid state switches 14 mounted to an alternating current bus bar 18a. An insulating material 22 is positioned adjacent to the bus bar 18a. The insulating material 22 electrically isolates control wires 26 from the alternating current bus bar 18a. Examples of potential insulating materials 22 include solids, liquids, gasses, or a vacuum.

In this example, control wires 26 facilitate electrical communication between the switches 14 throughout the mounting arrangement 11. For example, a plurality of bond wires 30 provide electrical communication between the switches 14, the alternating current bus bar 18a, and the control wires 26. The example insulating material 22 can be a solid, liquid, gas, or a vacuum. Furthermore, the insulating material 22 holds control wires 26 away from the alternating current bus bar 18a and communications can be routed through the bond wires 30.

A cover 34 houses each of the switches 14. The cover 34 is a dam and fill type cover that encapsulates the switches 14, for example. In other examples, the cover 34 is a polymer encapsulate such as a dispensed liquid cover or vapor deposition cover. The cover 34 may thereby encapsulate the switches 14, such as when the switches 14 are bare die switches. Other protective arrangements are also possible.

The switches 14 are mounted to the alternating current bus bar 18a. Example techniques for directly mounting the switches 14 include metallurgically bonding or soldering the switches 14 to the alternating current bus bar 18a. Other examples include using a polymer, such as epoxy, or mechanical attachment feature, such as a fastener, to secure the switches 14 to the alternating current bus bar 18a. Wire bonding, ribbon bonding, lead frame bonding, beam bonding, and other methods could also be used to secure the switches 14 to the alternating current bus bar 18a, for example.

Optionally, the alternating current bus bar 18a includes an interposer layer 36. The interposer layer 36 is a layer of a material having high thermal conductivity for thermally connecting the switch 14 to the bus bar 18a and low electrical conductivity for electrically isolating the switch 14 from the bus bar 18a. The switches 14 are mounted directly to at least a portion of the interposer layer 36 that is incorporated into the construction of the alternating current bus bar 18a. Alternatively, the switches 14 may be mounted to a printed wiring board, which is then attached to the bus bar.

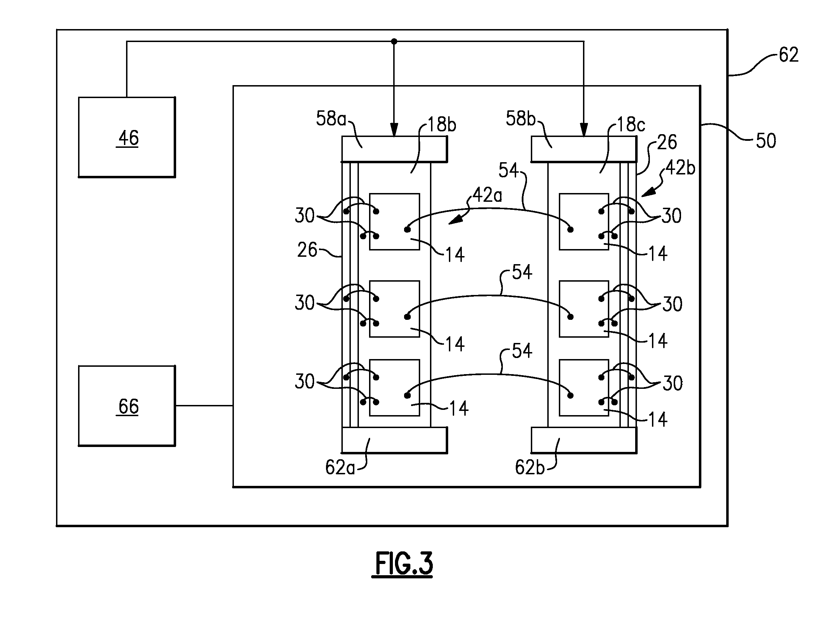

Figure 3 illustrates, an implementation of the example mounting arrangement of Figure 2 using mounting arrangements 42a and 42b, which each include multiple switches 14 and bus bars 18b, 18c. Each of the bus bars 18b, 18c has switches 14 mounted in a similar manner to the examples of Figures 1 and 2. A power supply 46 supplies power to the mounting arrangements 42a and 42b, which form a portion of a motor control unit 50, for example. A communication line 54 interconnects each of the switches 14 on the other mounting arrangement 42a, 42b.

The solid state switches 14 are gallium nitride based. In this example, the switches 14 are each mounted directly to the bus bars 18b, 18c, which are configured to carry electrical current within the motor control unit 50 between a first powered device 58a or 58b to a corresponding second powered device 58a or 58b. An additional feature of gallium nitride based semiconductor switches which is not found in semiconductor switches based in other materials is bidirectionality. Gallium nitride switches are capable of controlling current flowing in either the negative or the positive direction with a single switch, resulting in what is referred to as a "bidirectional" switch. The single bidirectional switch can then be used to control an alternating current bus bar without additional switches as would be required in systems utilizing unidirectional switches such as silicon, silicon carbide, or germanium based semiconductor switches. Thus power supply 46 may be a source of alternating current. The example of Figure 3 illustrates multiple bidirectional switches 14 mounted to the bus bars 18b, 18c to provide for redundant controls in the case of a failure condition occurring within one of the bidirectional switches 14.

Mounting the switches 14 directly to the bus bars 18b and 18c enables current moving through the bus bars 18b and 18c to power the switches 14. Mounting the switches 14 directly to the bus bars 18b and 18c also enables heat to move from the switches 14 to the bus bars 18b and 18c. The heat can then more effectively radiate to the surrounding environment. The example motor control unit 50 may be used within an aircraft 62, such as to monitor temperatures and vibrations.

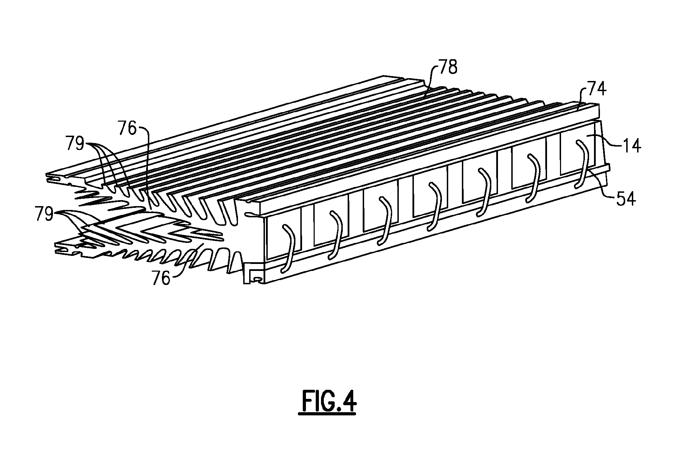

In the example of Figure 4, gallium nitride based semiconductor switches 14 are mounted directly to a bus bar 74 having a plurality of fins 78. The switches 14 generate heat during operation, which moves from the switches 14 to the bus bar 74. The fins 78 facilitate moving heat away from the bus bar 74 by increasing the surface area of the bus bar 74. In addition to the heat removal aspect of the bus bar 74, gallium nitride based switches are capable of operating at a higher temperature than other types of semiconductor switches, such as silicon or germanium. The illustrated fins 78 have a branching structure where two main fins 76 extend from the body of the bus bar, and each of the main fins 76 includes multiple secondary fins 79 branching away from the main fin 76. The branched structure provides a significant increase in the surface area of the bus fins 76, thereby increasing the fins' 76 ability to dissipate heat.

Features of the disclosed embodiments include mounting a gallium nitride based switch directly to a bus bar and using a gallium nitride based switch to perform electrical power switching functions. Another feature includes directly mounting a switch to an alternating current bus bar to facilitate removing heat from the switch.

Although a preferred embodiment has been disclosed, a worker of ordinary skill in this art would recognize that certain modifications would come within the scope of this invention. For that reason, the following claims should be studied to determine the true scope and content of this invention.

## Claims

1. A solid state switching arrangement comprising:
a first bus bar configured to carry electrical current; and
a gallium nitride based first switch mounted to the bus bar and in thermal communication with the bus bar such that the bus bar is a heat sink relative to the first switch.

2. The solid state switching arrangement of claim 1, wherein said gallium nitride based first switch comprises a bidirectional switch.

3. The solid state switching arrangement of claim 1 or 2, wherein said bus bar comprises an alternating current bus bar.

4. The arrangement of claim 1, 2 or 3, further comprising a second switch that is in electrical communication with the first switch, and the second switch is mounted directly to a second bus bar that is electrically isolated from the first bus bar; and preferably further comprising bond wires communicatively coupling said switches.

5. The arrangement of any preceding claim, wherein the first bus bar comprises a plurality of heat transfer fins.

6. The arrangement of any preceding claim, wherein the first switch is attached directly to the first bus bar.

7. The arrangement of any preceding claim, wherein the first switch is secured to an interposer layer that is secured to the first bus bar.

8. A solid state switching arrangement comprising:
a solid state switch;
an alternating current source; and
an alternating current bus bar configured to carry alternating electrical current from the source, wherein the solid state switch is directly mounted to the alternating current bus bar.

9. The arrangement of claim 8, further including a cover, wherein the cover comprises at least one of a dam and fill coating material, a coating material dispensed as a liquid, a protective cap, or a vapor deposited material; and preferably wherein said cover is a sealed cover covering said switch and partially covering said bus bar.

10. The arrangement of claim 8 or 9, wherein the alternating current bus bar comprises a plurality of heat transfer fins.

11. The arrangement of claim 8, 9 or 10, wherein said solid state switch comprises a bidirectional semiconductor switch; and preferably wherein said solid state switch is gallium nitride based.

12. A method of arranging a switch comprising:
mounting a first gallium nitride based switch directly to a bus bar such that the bus bar can act as a heat sink relative to the first gallium nitride based switch, and such that the first gallium nitride based switch can control current flow through the bus bar; and
electrically connecting the first gallium nitride based switch to a control signal wire.

13. The method of claim 12, including electrically connecting the first gallium nitride based switch to a second gallium nitride based switch that is mounted to a second bus bar.

14. The method of claim 13, wherein said mounting comprises at least one of metallurgically mounting, adhesively mounting, or mechanically mounting.

15. The method of claim 12, 13 or 14, wherein said mounting comprises securing the first gallium nitride based switch to an interposer layer that is secured to the bus bar.
